Europäisches Patentamt

European Patent Office

Office européen des brevets

(11) Numéro de publication: **0 333 247 B1**

# FASCICULE DE BREVET EUROPEEN

(45) Date de publication de fascicule du brevet: **24.11.93** (51) Int. Cl.5: **H01P 5/16**, H03H 7/48

(21) Numéro de dépôt: **89200539.8**

(22) Date de dépôt: **06.03.89**

(54) **Répartiteur de puissance pour signal H.F.**

(30) Priorité: **11.03.88 FR 8803195**

(43) Date de publication de la demande:
**20.09.89 Bulletin 89/38**

(45) Mention de la délivrance du brevet:
**24.11.93 Bulletin 93/47**

(84) Etats contractants désignés:
**DE ES FR GB**

(56) Documents cités:
**FR-A- 2 101 207**
**GB-A- 1 143 915**
**US-A- 4 367 445**

**ELECTRONIC DESIGN, vol. 28, no. 15, 19 juillet 1980, pages 181-187, Rochelle Park, US; H.O. GRANBERG: "Combine power without compromising performance"**

(73) Titulaire: **PHILIPS ELECTRONIOUE GRAND PUBLIC**
**51, Rue Carnot**
**F-92150 Suresnes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE ES GB**

(72) Inventeur: **Hervé, Vincent Société Civile S.P.I.D.**
**209, rue de l'Université**
**F-75007 Paris(FR)**

(74) Mandataire: **Charpail, François et al**
**Société Civile S.P.I.D.**
**156, Boulevard Haussmann**
**F-75008 Paris (FR)**

## Description

La présente invention a pour objet un répartiteur de puissance pour signal à haute fréquence, dont les sorties sont mutuellement isolées et ont la même impédance que l'entrée, et comportant, montés en série, un répartiteur dit "Wilkinson" et un déphaseur différentiel.

Des répartiteurs sont notamment utilisés pour répartir un signal provenant d'antennes de réception de télévision.

Pour des fréquences pas trop élevées, un répartiteur connu est composé d'un transformateur d'impédance monté en série avec un déphaseur à ferrite.

Pour des fréquences plus élevées il est connu d'utiliser un répartiteur dit "Wilkinson" tel que décrit dans la publication "IRE Transactions MTT, Jan. 1960, p.116-118".

Enfin, un répartiteur selon le préambule ci-dessus est connu du document FR-A-2.101.207. Selon ce document, de bons résultats sont obtenus dans une bande de fréquences d'une octave.

L'invention a pour but de procurer un répartiteur à plus large bande.

A cet effet, un répartiteur conforme à la présente invention est particulièrement remarquable en ce que, pour constituer un répartiteur fonctionnant dans une bande de 50 à 1750 MHz, le déphaseur différentiel est du type à ferrite et est suivi d'une résistance d'équilibrage symétrique, et le répartiteur comporte à son entrée un transformateur d'impédance, la longueur des branches du répartiteur dit "Wilkinson" est plus petite que ce qu'elle serait pour un répartiteur dit "Wilkinson" employé seul, et la résistance d'équilibrage est plus grande que ce qu'elle serait pour un déphaseur différentiel employé sans le répartiteur dit "Wilkinson" qui le précède.

Un tel répartiteur est notamment avantageux de part sa simplicité, et donc son coût, de réalisation.

Dans les éléments de base du répartiteur mentionnés ci-dessus les composants électriques ont, lorsqu'ils sont employés seuls, des caractéristiques connues telles que impédance, longueur.

Dans un répartiteur conforme à la présente invention, il est particulièrement remarquable d'utiliser les caractéristiques suivantes :

- le rapport du transformateur d'impédance est sensiblement de 1/2 (± 20%),
- l'impédance de chaque branche du "Wilkinson" est sensiblement égale à 4/3 (± 20 %) de l'impédance d'entrée,
- la longueur de chaque branche du "Wilkinson" est sensiblement égale à $\lambda/8$ (± 20 %) de la fréquence moyenne de la large bande,

- l'impédance de la résistance d'équilibrage du déphaseur à ferrite est sensiblement égale à 4 fois (± 20 %) l'impédance d'entrée.

Avec de telles valeurs, on constate que le répartiteur fournit d'excellentes performances.

Dans le cas de la réception de télévision, par exemple avec une gamme d'onde de 40 MHz à 1750 MHz et une impédance d'antenne de 75 $\Omega$, il est avantageux d'utiliser les valeurs suivantes :

- l'impédance de chaque branche du "Wilkinson" est de 100 $\Omega$,
- la longueur de chaque branche du "Wilkinson" est de 2 cm,
- l'impédance de la résistance d'équilibrage du déphaseur à ferrite est de 300 $\Omega$.

Avec ces valeurs le facteur d'isolation des sorties dans la gamme d'onde considérée est satisfaisant.

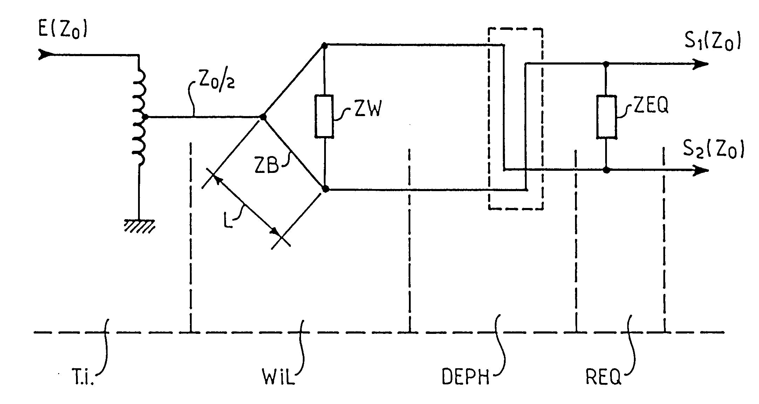

L'invention sera mieux comprise à l'aide de la description d'un exemple de réalisation en regard du dessin ci-après qui représente un répartiteur conforme à l'invention.

Le répartiteur est muni d'une entrée (E1) d'impédance Zo et de deux sorties ($S_1$, $S_2$) d'impédance Zo également ; dans tous les cas les sorties doivent être mutuellement isolées c'est à dire qu'un signal indésirable entrant par une sortie ne doit pas se retrouver sur l'autre sortie; il est donc clair que le dispositif doit toujours être symétrique.

Le répartiteur comporte un transformateur d'impédance (Ti), un déphaseur (DEPH) à ferrite et une impédance d'équilibrage (ZEQ). C'est le déphaseur qui assure l'isolement recherché ; ces seuls éléments conviennent bien pour la gamme d'onde 40 MHz - 860 MHz; pour une impédance d'entrée de 75 $\Omega$, l'impédance d'équilibrage serait, avec ces seuls éléments, de 150 $\Omega$.

Entre le transformateur d'impédance et le déphaseur à ferrite est placé un répartiteur "Wilkinson", réalisé en "microstrip" sur un circuit epoxy double face. Le déphasage serait normalement assuré par un trajet plus long de deux fois $\lambda/4$ pour la partie du signal indésirable qui circule dans les deux branches d'impédance $ZO\sqrt{2}$ ; cette disposition conviendrait bien pour la gamme 950 MHz - 1750 MKz; la longueur de chaque branche serait alors de 3 cm (soit le quart de la longueur d'onde, c'est-à-dire $\lambda/4$ à la fréquence moyenne

$$\frac{50+1750}{2} \quad ),$$

et les impédances représentées seraient respectivement de Zo $\sqrt{2}$ = 106 $\Omega$, et 2Zo = 150 $\Omega$.

Pour réaliser un répartiteur large bande, l'homme du métier pourrait être tenté de combiner les trois éléments Ti, WiL, DEPH connus ci-dessus décrits ; toutefois la manière de dimensionner ces éléments n'est pas évidente : il reste encore à trouver les valeurs électriques correctes, en supposant qu'elles existent ce qui n'est pas certain car rien ne garantit, électriquement parlant, qu'il existe une combinaison débouchant sur une solution techniquement valable.

Dans le répartiteur large bande conforme à l'invention, qui comporte donc en série un transformateur d'impédance (Ti), un circuit similaire à un "Wilkinson" (WiL), un déphaseur à ferrite (DEPH), et une impédance d'équilibrage (ZEQ), avec une impédance d'entrée de Zo = 75 Ω et pour la gamme d'onde 40 MHz - 1750 MHz, des valeurs électriques adéquates sont les suivantes :

- rapport du transformateur d'impédance 1/2,
- impédance de chaque branche ZB = 100 Ω - (soit 4/3 de Zo)
- impédance ZW = 75 Ω (soit = Zo)
- longueur de chaque branche L = 2 cm (soit λ/8 à la fréquence moyenne

$$\frac{40+1750}{2} \; MHz)$$

- impédance d'équilibrage ZEQ = 300 Ω (soit 4 fois Zo)

Avec ces valeurs, la courbe d'isolation mutuelle des sorties S1 et S2 est satisfaisante pour la gamme de fréquence considérée.

Ces valeurs sont surprenantes pour l'homme du métier. En effet :
- l'abaissement, par rapport à un "Wilkinson" seul, de la fréquence moyenne devrait logiquement conduire à une augmentation de la longueur de chaque branche du "Wilkinson", or c'est le contraire que l'on constate avec une diminution de moitié.
- les impédances d'entrée et de sortie étant inchangées, on devrait logiquement utiliser les mêmes valeurs que pour des éléments individuels, or la valeur de l'impédance d'équilibrage ZEQ a été multipliée par 2.

**Revendications**

1. Répartiteur de puissance pour signal à haute fréquence, dont les sorties sont mutuellement isolées et ont la même impédance que l'entrée, et comportant, montés en série :
   - un répartiteur dit "Wilkinson"
   - un déphaseur différentiel
   caractérisé en ce que, pour constituer un répartiteur fonctionnant dans une large bande allant de 50 à 1750 MHz, le déphaseur différentiel est du type à ferrite et est suivi d'une résistance d'équilibrage symétrique, et le répartiteur comporte à son entrée un transformateur d'impédance, la longueur des branches du répartiteur dit "Wilkinson" est plus petite que ce qu'elle serait pour un répartiteur dit "Wilkinson" employé seul, et la résistance d'équilibrage est plus grande que ce qu'elle serait pour un déphaseur différentiel employé sans le répartiteur dit "Wilkinson" qui le précède.

2. Répartiteur selon la revendication 1, caractérisé en ce que
   - le rapport de transformation d'impédance est sensiblement de 1/2 (± 20%),
   - l'impédance de chaque branche du "Wilkinson" est sensiblement égale à 4/3 (± 20%) de l'impédance d'entrée,
   - la longueur de chaque branche du "Wilkinson" est sensiblement égale à λ/8 (± 20%) de la fréquence moyenne de la large bande,
   - l'impédance de la résistance d'équilibrage du déphaseur à ferrite est sensiblement égale à 4 fois (± 20%) l'impédance d'entrée.

3. Répartiteur selon la revendication 2, destiné à une gamme d'onde de 40 MHz à 1750 MHz, et pour une impédance d'entrée de 75 Ω, caractérisé en ce que
   - l'impédance de chaque branche du "Wilkinson" est de 100 Ω,
   - la longueur de chaque branche du "Wilkinson" est de 2 cm,
   - l'impédance de la résistance d'équilibrage du déphaseur à ferrite est de 300 Ω.

**Claims**

1. Power divider for a HF signal, whose outputs are mutually isolated and have the same impedance as the input, and comprising in a series combination a power divider called "Wilkinson" power divider and a different phase shifter, characterized in that the differential phase shifter is of the ferrite type to form a power divider which operates in a band from 50 to 1750 MHz and is followed by a symmetrical balancing resistor, and the power divider comprises at its input an impedance transformer, the length of the "Wilkinson" power divider branches is smaller than it would be for a solely used "Wilkinson" power divider and the balancing resistor is larger than it would be for a differential phase shifter used without the "Wilkinson" power divider preceding the phase shifter.

**2.** Power divider as Claimed in Claim 1, characterized in that

- the ratio of the impedance transformation is substantially 1/2 (± 20%),
- the impedance of each branch of the "Wilkinson" power divider is substantially equal to 4/3 (± 20%) times the input impedance,
- the length of each branch of the "Wilkinson" power divider is substantially equal to $\lambda/8$ (± 20%) of the medium frequency of the wide band,
- the impedance of the balancing resistor of the ferrite phase shifter is substantially equal to 4 times (± 20%) the input impedance.

**3.** Power divider as claimed in Claim 2, intended for a wave range from 40 MHz to 1750 MHz and for an input impedance of 75 $\Omega$, characterized in that:

- the impedance of each branch of the Wilkinson power divider is 100 $\Omega$,
- the length of each branch of the Wilkinson power divider is 2 cm,
- the impedance of the balancing resistor of the ferrite phase shifter is 300 $\Omega$.

**Patentansprüche**

**1.** Leistungsverteiler für ein HF-Signal, wobei die Ausgänge des Verteilers gegenüber einander isoliert sind und die gleiche Impedanz wie der Eingang haben und wobei ein als "Wilkinson"-Leistungsverteiler bezeichneter Leistungsverteiler und ein Differentiaiphasenschieber in Reihe verbunden sind, dadurch gekennzeichnet, daß der Differential-Phasenschieber vom Ferrit-Typ ist zum Bilden eines Leistungsverteilers, der in einem Bandbereich von 50 bis 1750 MHz arbeitet, wobei diesem Leistungsverteiler ein symmetrischer Abgleichwiderstand nachgeschaltet ist, und wobei der Leistungsverteiler am Eingang einen Impedanzwandler aufweist, wobei die Lange der "Wilkinson"-Leistungsverteilerzweige kleiner ist als diese für einen einzeln verwendeten "Wilkinson"-Leistungsverteilersein würde und wobei der Abgleichwiderstand größer ist als er für einen Differential-Phasenschieber ohne vorgeschalteten "Wilkinson"-Leistungsverteiler wäre.

**2.** Leistungsverteiler nach Anspruch 1, dadurch gekennzeichnet, daß:

- das Impedanzumwandlungsverhältnis nahezu 1/2 (± 20%) ist,
- die Impedanz jedes Zweiges des "Wilkinson"-Leistungsverteilers nahezu gleich 4/3 (± 20%) der Eingangsimpedanz ist,
- die lange jedes Zweiges des "Wilkinson"-Leistungsverteilers nahezu gleich $\lambda/8$ (± 20%) der mittleren Frequenz des Breitbandes ist,
- die Impedanz des Abgleichwiderstandes des Ferrit-Phasenschiebers nahezu gleich der vierfachen Eingangsimpedanz (± 20%) ist.

**3.** Leistungsverteiler nach Anspruch 2, für einen Bereich von 40 MHz bis 1750 MHz und für eine Eingangsimpedanz von 75 Ohm, dadurch gekennzeichnet, daß:

- die Impedanz jedes Zweiges des "Wilkinson"-Leistungsverteilers 100 Ohm beträgt,
- die Länge jedes Zweiges des "Wilkinson"-Leistungsverteilers 2 cm beträgt,
- die Impedanz des Abgleichwiderstandes des Ferrit-Phasenschiebers 300 Ohm beträgt.

$E(Z_0)$

$S_1(Z_0)$

$S_2(Z_0)$

$Z_0/2$

ZW

ZB

L

ZEQ

T.i. WiL DEPH REQ